Europäisches Patentamt

European Patent Office

Office européen des brevets

(11) Publication number: **0 408 060 A2**

## (12) EUROPEAN PATENT APPLICATION

(21) Application number: **90113461.9**

(22) Date of filing: **13.07.90**

(51) Int. Cl.5: **H01L 23/525**, H01L 27/118

(30) Priority: **14.07.89 JP 182264/89**

(43) Date of publication of application:
**16.01.91 Bulletin 91/03**

(84) Designated Contracting States:
**DE FR GB IT**

(71) Applicant: **HITACHI, LTD.**
**6, Kanda Surugadai 4-chome**
**Chiyoda-ku, Tokyo 100(JP)**

(72) Inventor: **Usami, Mitsuo**
**657-5, Nogami**
**Ohme-shi, Tokyo(JP)**
Inventor: **Akimori, Hiroyuki**
**7-2-27 Kabe-machi**
**Ohme-shi, Tokyo(JP)**

(74) Representative: **Strehl, Schübel-Hopf,**
**Groening**
**Maximilianstrasse 54 Postfach 22 14 55**
**D-8000 München 22(DE)**

(54) Semiconductor integrated circuit device and logic correcting method of the same.

(57) A semiconductor integrated circuit device comprises logic elements provided on a semiconductor substrate and laminated wiring layers formed by alternately laminating insulation layers (111) and wiring layers (S1 - S5) on the logic elements. The logic elements are connected by the laminated wiring layers. The laminated wiring layers are formed by a lower wiring layer (LL; S1 - S3) and an upper wiring layer (UL; S4 - S5) laid on the lower wiring layer. Part of a net connecting the logic elements includes terminals (140 - 147) in the upper wiring layer (UL) and is connected therewith. Namely, part of the net passes through the upper wiring layer (UL). The semiconductor integrated circuit device further comprises unused logic elements not connected with any other logic elements and a logic element having a disable terminal (300), wherein input/output terminals (214, 216, 218) of the unused logic element and the disable terminal (300) are led into the upper wiring layer (UL). Logic correction of the semiconductor integrated circuit device is carried out by altering connecting pattern between the terminals (140 - 147) at a part of the net using the upper wiring layer, connecting the input/output terminals (214, 216, 218) of the unused logic element with the other terminals (210a, 210b) and connecting the disable terminal (300) to the predetermined wirings. Namely, the wiring layers (S1, S2, .....) are structured in the semiconductor integrated circuit device provided with many laminated wiring layers (S1, S2, .....) so that correction of wiring layers may be realized only at the upper wiring layer UL.

FIG. 1a

FIG. 1b

EP 0 408 060 A2

## SEMICONDUCTOR INTEGRATED CIRCUIT DEVICE AND LOGIC CORRECTING METHOD OF THE SAME

Background of the Invention

The present invention relates to a technique which may be effectively applied for semiconductor integrated circuit device and particularly to a technique effectively applied to semiconductor integrated circuit device comprising many laminated wiring layers.

As a semiconductor integrated circuit device having many laminated wiring layers, a semiconductor integrated circuit device employing a master slice system, for example, a gate array has been known. In the master slice system, after conducting a process called a master process to previously form basic cells comprising MISFET (Metal-Insulator-Semiconductor-Field-Effect-Transistor), Bipolar transistor or Bi-CMOS (Bipolar Complementary Metal Oxide Semiconductor) on a semiconductor substrate in the form of a matrix, a wafer (master wafer) is stoked, and logic circuits and memories (Random Access Memory (RAM), Read Only Memory (ROM)) are structured by forming and laminating wiring layers on the stoked master wafer in the process called the slice process in accordance with user specification (user's requirement).

Namely, in the semiconductor integrated circuit device employing the master slice system, the internal elements of basic cells regularly arranged in the form of a matrix and basic cells are connected with a plurality of layers of wiring. These connections form logic elements and logic circuits are structured by connecting such logic elements. The logic elements include logic gates such as NAND, NOR, etc., flipflop circuits and latch circuits. Since the semiconductor integrated circuit device employing the master slice system of this type is capable of forming various kinds of logic circuits only by changing wiring patterns, a wide variety of circuits may be developed within a short period of time.

The wirings of semiconductor integrated circuit device which has employed the master slice system can be formed by the computer-aided automatic layout and wiring system (DA: Design Automation).

The logic elements are registered as the macro cells to DA, while information such as interbasic cell connection pattern, delay parameter and symbol diagrams are also registered for each macro cell. DA executes logic simulation, automatic layout and determination of internal circuits of memory.

The inventors of the present invention have found such a problem in the slice process explained above that if an error is found in the logic structure (logic circuit), wiring must often be corrected and in this case, correction is very complicated and quick correction is impossible because the masks for all wiring layers from the upper to lower layers must be reformed for the purpose of correction.

A method of correcting the logic structure is disclosed in the Japanese Laid-open Patent No. 61-125045. This reference describes the technique that a wiring for correction extending from the one end to the other end of wiring channel region is provided between the signal wirings on each wiring layer over the wiring channel region and logic structure is corrected with the wiring for correction.

Moreover, improvement in multilayered wirings has been accelerated in these years and products including many laminated wiring layers are increasing. But, increased number of wiring layers requires more wiring layers to be corrected. Thereby correcting time (period) becomes longer and quick correction is no longer possible. Particularly, correction of error in the logic structure found after OS (operating system) is operated requires a longer correcting time.

Another method of correcting logic structure by changing connecting pattern is also described in the Japanese Laid-open Patent No. 60-79746.

This reference describes a technique that at least a part of signal wires connected to the circuit elements of semiconductor device is formed as the uppermost layer of wiring layers and the logic structure is corrected by cutting or connecting the wirings in this uppermost wiring layer.

In this technique , since the connecting pattern is changed only at the uppermost wiring layer, correction of wiring has a small degree of freedom and in the worst case, logic correction is sometimes impossible. In some cases, wiring length becomes longer and thereby delay time becomes large due to the correction of wirings and thereby reliability of circuit operation is lowered. Namely, in this method, the range of logic correction (degree of freedom of logic correction) is limited.

Moreover, the Japanese Laid-open Patent No. 59-181643 describes a technique that in the semiconductor integrated circuit of the master slice system in the double wiring layer structure, an unused logic gate is prepared and logic correction is carried out by altering connecting pattern only at the final (uppermost) wiring layer.

Summary of the Invention

Considering such problems, the present invention has been proposed and it is therefore an object of the present invention to provide a semiconductor integrated circuit device which is capable of correcting wiring layers within a short period of time (short term) irrespective of the number of wiring layers.

It is another object of the present invention to provide a logic correcting method which is capable of improving a degree of freedom in correction of logic structure (logic correction) in a semiconductor integrated circuit device.

It is still another object of the present invetion to provide a technique to improve reliability of a semiconductor integrated circuit device which has corrected logic structure.

The aforementioned and other objects of the present invention and moreover novel features thereof will become apparent from description of the present specification and the accompanying drawings thereof.

The typical inventions disclosed in this specification are briefly explained hereunder.

(1) In a semiconductor integrated circuit device comprising many laminated wiring layers, the laminated wiring layer is formed so that correction of wiring layers may be conducted only at the upper wiring layer.

Moreover, wiring layers are structured so that a part of wirings connecting logic elements passes through the upper wiring layer.

In addition, unused logic element (unused logic element not connected with the other logic elements) is provided, and the input/output terminals of unused logic element are respectively guided to the upper wiring layer.

(2) According to the logic correcting method of semiconductor integrated circuit device, in a semiconductor integrated circuit device comprising many laminated wiring layers, a part of wiring connecting logic elements is formed by connecting terminals provided on the lowest wiring layer in the uper wiring layer with the upper wiring layer and logic structure is corrected by correcting the upper wiring layer.

Moreover, according to the logic correcting method for correcting logic structure, the input-output terminals of unused logic element are guided to the upper wiring layer, and the upper wiring layer is connected to this input-output terminal.

According to the method (1) mentioned above, since the laminated wiring layer is formed so that correction of wiring layer may be conducted only at the upper wiring layer, only the upper wiring layer is corrcted without reforming all layers and thereby correcting of wiring layer can be realized within a short period of time (short term) without relation to the number of wiring layers.

In addition, since logic correction is realized at the upper wiring layer formed by a plurality of wiring layers, improvement in a degree of freedom of logic correction can be improved and logic correction can also be completed easily.

According to the method (2), the step for correcting the connecting pattern of the lower wiring layer formed under the upper wiring alyer can be eliminated and thereby processing steps of automatic design system can be as much reduced and logic correction can be realized within a short period (short term).

In regard to a structure of the present invention, an embodiment of a semiconductor integrated circuit devide employing the master slice system to which the present invention is applied will be explained with reference to the accompanying drawings.

The like elements are denoted by the like reference numerals throughout the drawings and same explanation will not be repeated.

Brief Description of the Drawings

Fig. 1a is a vertical sectional view indicating a first embodiment of a semiconductor integrated circuit device of the present invention;

Fig. 1b is logic circuit of the semiconductor integrated circuit device shown in Fig. 1a;

Fig. 2a is a vertical sectional view of the semiconductor integrated circuit device shown in Fig. 1a after correction;

Fig. 2b is a logic circuit of the semiconductor integrated circuit device shown in Fig. 2a;

Fig. 3a is a process flowchart indicating a method of forming the semiconductor integrated circuit device of the first embodiment of the present invention;

Fig. 3b is a process flowchart of wiring function supported in the automatic wiring step shown in Fig. 3a;

Fig. 3c is a process flowchart indicating logic correcting method of the semiconductor integrated circuit device of the first embodiment of the present invention;

Fig. 4a is a plan view indicating a basic outline structure of the semiconductor integrated circuit device of the first embodiment of the present invention;

Fig. 4b is a diagram indicating layout of logic elements in the essential portion of basic cell array of Fig. 4a;

Fig. 5a is a vertical sectional view indicating a second embodiment of the semiconductor integrated circuit device of the present inveniton;

Fig. 5b is a logic circuit of the semiconductor integrated ciricuit device shown in Fig. 5a;

Fig. 6a is a vertical sectional view of the semiconductor integrated circuit device shown in Fig. 5a after correction;

Fig. 6b is a logic circuit of the semiconductor integrated circuit device shown in Fig. 6a;

Fig. 7 is a diagram indicating layout of unused logic elements;

Fig. 8 is a vertical sectional view indicating a third embodiment of the semiconductor integrated circuit device of the present invention;

Fig. 9 is a logic circuit of the semiconductor integrated circuit device shown in Fig. 8;

Fig. 10a is a vertical sectional view indicating a fourth embodiment of the semiconductor integrated circuit device of the present invention;

Fig. 10b is a logic circuit of the semiconductor integrated circuit device shown in Fig. 10a;

Fig. 11a is a vertical sectional view of the semiconductor integrated circuit device shown in Fig. 10a after correction;

Fig. 11b is a logic circuit of the semiconductor integrated circuit device shown in Fig. 11a.

Description of the Preferred Embodiment

A preferred embodiment of the present invention will be explained in detail with reference to the accompanying drawings.

Embodiment 1:

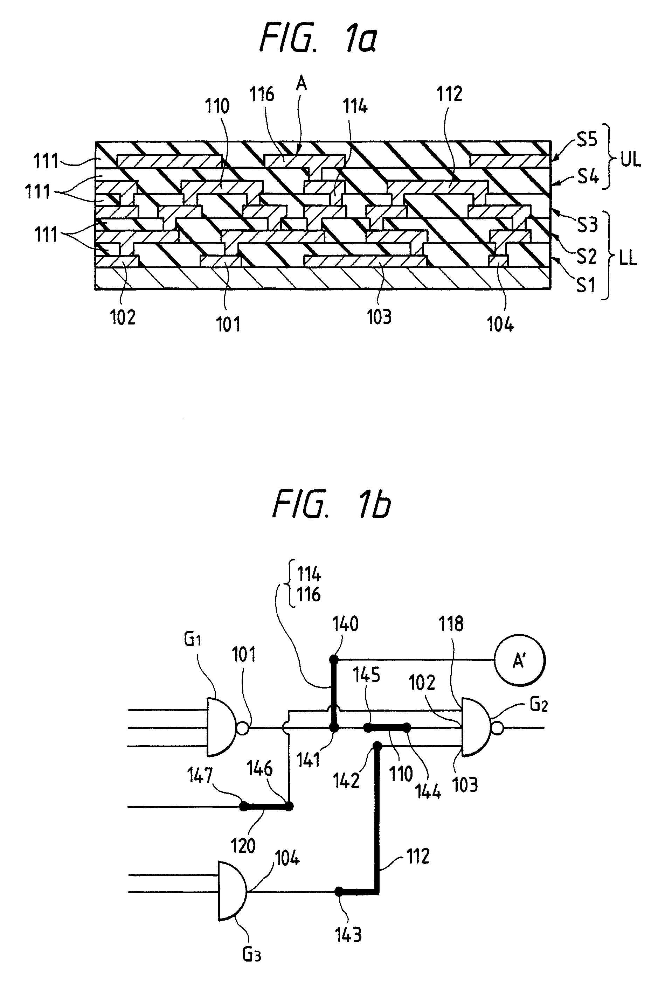

Fig. 1a is a vertical sectional view indicating a first embodiment of the semiconductor integrated circuit device of the present invention and Fig. 1b is a logic circuit of the semiconductor integrated circuit device shown in Fig. 1a.

A semiconductor integrated circuit device of the first embodiment is an LSI for logic or memory circuit.

As shown in Fig. 1a, a semiconductor integrated circuit device of this embodiment is formed by a quintuple-layer wiring structure and S1, S2, S3, S4, S5 respectively show the first, second, third, fourth and fifth wiring layers. The first, second and third wiring layers S1, S2, S3 form the lower wiring layer LL, while the fourth and fifth layers S4, S5 form the upper wiring layer UL. Each wiring layer of S1 - S5 is respectively separated by an interlayer insulating film 111. Namely, the semiconductor integrated circuit device is formed as a multilayer wiring structure laminating alternately the wiring layers and interlayer insulating films 111.

In Fig. 1b, the gates G1, G2, G3 respectively indicate logic elements. The gates G1, G2 are 3-input NAND gates, while the gate G3 is 2-input AND gate.

The logic elements including the gates G1, G2, G3 are formed by the not illustrated basic cells structured by CMOS, bipolar or Bi-CMOS.

The wirings in the logic element G are mainly connected by the lower wiring layer LL, while the wirings between logic gates are connected by the upper wiring layer UL and lower wiring layer LL. The wiring connecting between the logic elements G to give equal potential is called a net. The reference numeral 101 denotes an output temrinal of gate G1, while 102, 103, input terminals of gate G2 and 104, an output terminal of gate G3. As shown in Fig. 1a, a part of wiring connecting the output terminal 101 of gate G1 and input terminal 102 of gate G2 passes through the fourth wiring layer S4 and is formed by the wiring 110 of fifth layer.

A part of wiring connecting the input terminal 103 of gate G2 and output terminal 104 of gate G3 passes through the fourth wiring layer S4 and is formed by the wiring 112 of fourth layer. A part of wiring to the not illustrated other gate (logic element) A′ from the output terminal 101 of gate G1 passes through the part A in the wiring layer S5 of fifth layer. Namely, a part of the wiring connecting the input terminal of gate A′ and the output terminal 101 of gate G1 passes through the fourth and fifth wiring layers S4, S5 and is formed by the wirings 114, 116 of the fourth and fifth layers.

As explained above, a part of net connecting the gate G1, gate G2 and gate A′ passes through the wirings 110, 114, 116 of the fourth and fifth layers, namely passes through the upper wiring layer UL. Moreover, a part of wiring connecting the output terminal 118 of gate G2 and not illustrated other gates (logic elements) passes through the wiring 120 formed by the upper wiring layer UL.

As explained above, in the first embodiment, all wirings connecting logic elements always pass partly through the upper two layers as the upper wiring layers (in the case of this embodiment, the wiring layers S4, S5 of the fourth and fifth layers or the fourth wiring layer S4 of the fourth layer since the five wiring layers are used).

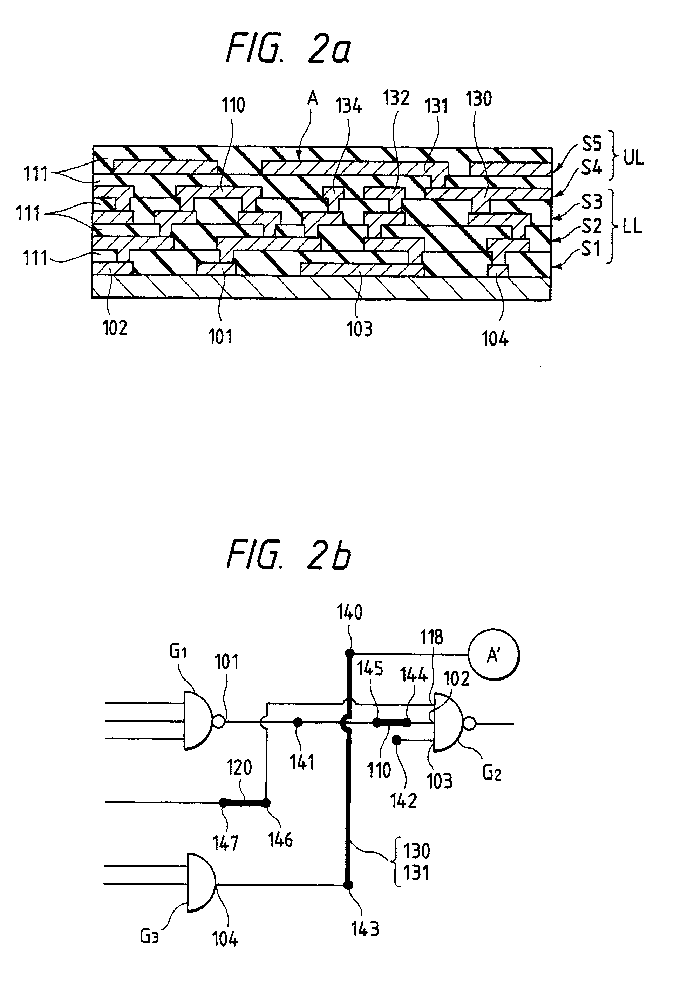

Accordingly, in case the semiconductor integrated circuit device is changed as shown in Fig. 2b, namely in case the wiring to the not illustrated other gate A′ (except for gate G2) from the output terminal 101 of gate G1 and the wiring connecting the input terminal 103 of gate G2 and output terminal 104 of gate G3 are respectively cut, as shown in Fig. 2a, to connect the output temrinal 104 of gate G3 to the output terminal 103 of gate G3, the wirings are cut and connected only at the wiring layers S4, S5 of the fourth layer and fifth layer as the upper wiring layers.

Namely the wiring 112 of fourth layer is cut and the output terminal 104 of gate G3 is connected to the part A in the wiring layer S5 of fifth layer through the wiring 130 of fourth layer and the wiring 132 of fifth layer. The input terminal 103 of gate G2 is connected, for example, to the not illustrated wiring which gives high level "1" through the fourth wiring layer 132. Thereby, the gate G2 forms a 2-input NAND having the input terminals 102, 118. The fourth wiring layer 134 connected to the output terminal 101 of gate G1 is not connected with the other wiring layer.

As explained above, since all wirings connecting the logic gates always pass partly through the upper two layers as the upper wiring layer UL in the first embodiment (fourth and fifth wiring layers S4, S5 or fourth wiring layer S4 since five wiring layers are formed in this embodiment), logic correction can be made by correction (mask correction) of only the upper wiring layer UL (S4, S5 layers in this embodiment) on which a part of wirings passes through, without reforming all layers S1 - S5.

Therefore, as explained above, it is enough to correct only the upper wiring layer UL without correcting the lower wiring layers LL S1, S2, S3. As a result, in case the number of wiring layers increases, correction of wiring layer, namely correction of logic structure may be realized within a short period of time (short term).

Moreover, since correction of logic structure is carried out using the upper wiring layer UL consisting of two layers of the fourth and fifth wiring layers S4, S5. In addition, since the corrected wirings 130, 132 can be set short, increase of delay time in the corrected logic structure can be prevented and reliability of circuit operation may be improved.

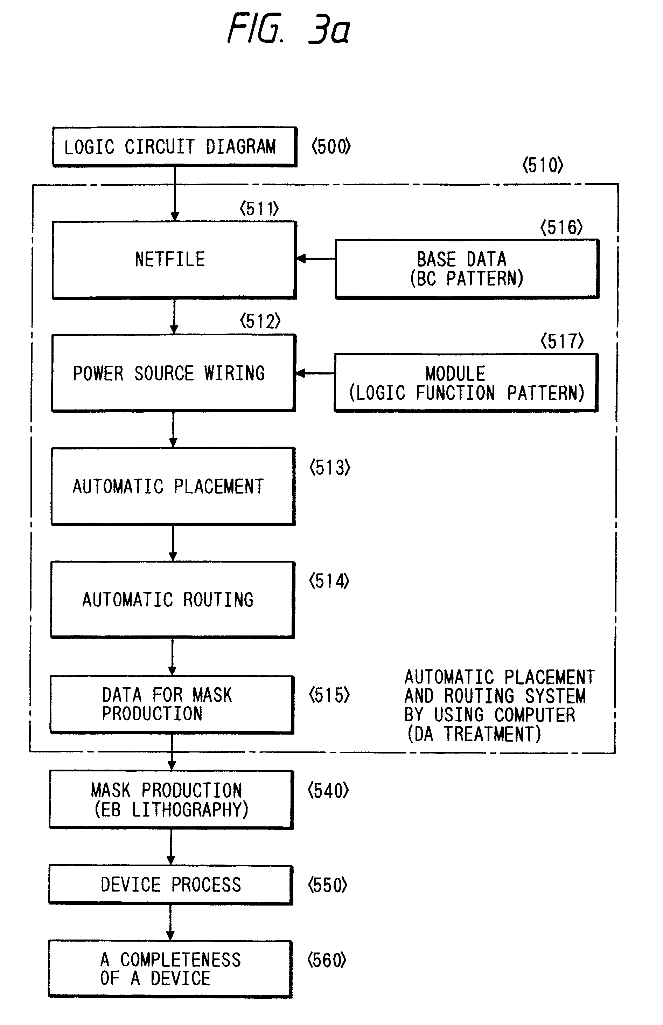

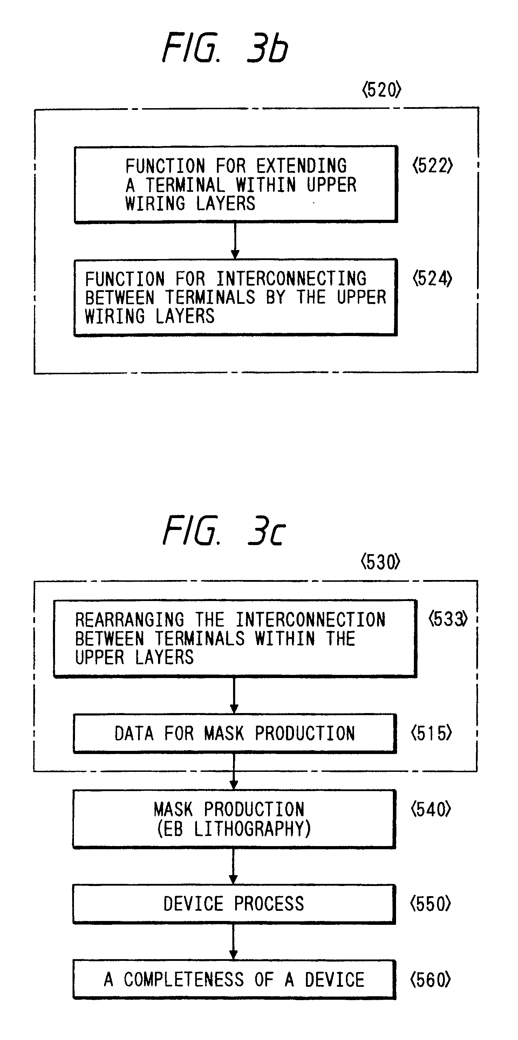

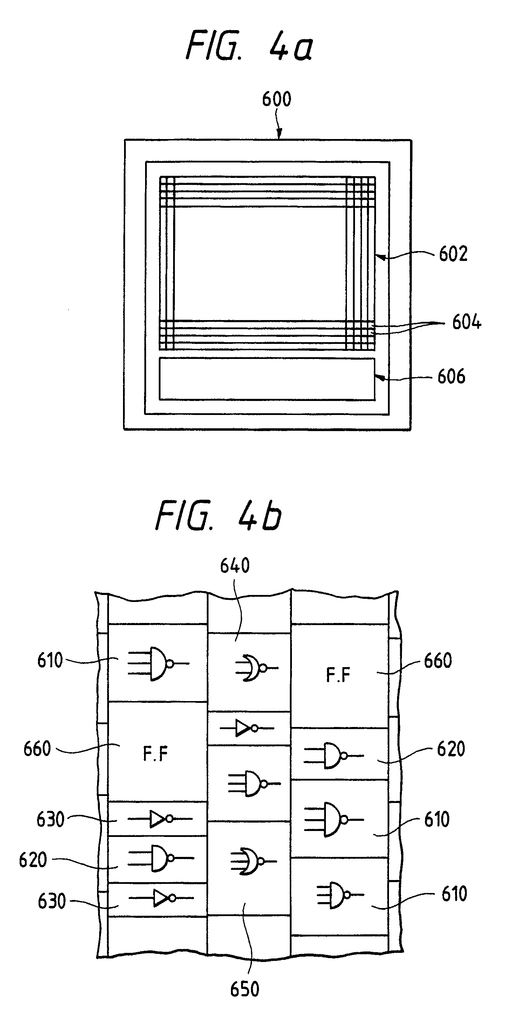

Next, a method of forming a semiconductor integrated circuit device mentioned above will be briefly explained with reference to Fig. 3 and Fig. 4.

As shown in Fig. 3 (process flowchart), a logic structure function to be mounted on the semiconductor integrated circuit device is first designed to form a logic circuit diagram <500>.

Next, the layout and connections of logic circuits are automatically designed, based on the logic circuit diagram, with the automatic layout and wiring system (Design Automation) using a computer <510>. In the DA system, the connecting information is input to the DA system as the net file which may be processed by the DA system on the basis of the logic circuit diagram <511>.

Next, the power supply wirings are automatically arranged <512> on a virtually expressed semiconductor integrated circuit device (base chip) which is stored in the base data <516> of DA system. The base data <516> is the information wherein the basic cell patterns are arranged on the semiconductor integrated circuit device (base chip).

Thereafter, the designed logic circuits are automatically arranged <513> based on the connecting information input to the DA system. Automatic layout of logic circuits is carried out by automatically arranging the modules (logic function patterns) <517> stored in the DA system along the basic cell patterns.

Thereby, the logic elements 610, 620, 630, 640, 650 and 660 of the logic gate, fllipflop circuit shown in Fig. 4b are arranged, corresponding to the basic cell array region (logic circuit region) 602 of the semiconductor integrated circuit device 600 employing the master slice system at the sea of gates, for example, shown in Fig. 4a.

In Fig. 4b, the reference numeral 610 denotes 3-input NAND circuit forming region; 620, 2-input NAND circuit forming region; 630, inverter forming region; 640, 2-input OR circuit forming region; 650, 3-input OR circuit forming region; 660, flipflop circuit forming region. Moreover, in Fig. 4a, the reference numeral 604 denote basic cell; 606, macro cell such as RAM or ROM. The basic cell 604 is closely arranged in the form of a matrix, unlike the fixed channel system, without interposition of wiring forming region (wiring channel region). A semiconductor integrated circuit device employing the master slice system having Bi-CMOS as the basic cell is described, for instance, in the ISSCC DIGEST OF TECHNICAL PAPERS, P. 116-117; Feb., 1989. Moreover, CMOS sea of gates array is described, for examaple, in the ISSCC DIGEST OF TECHNICAL PAPERS, P. 72-73, Feb., 1988.

It is a matter of course that the present invention can be applied not only to the semiconductor integrated circuit device 600 employing the master slice system at the sea of gates but also to the semiconductor integrated circuit device employing the master slice system of the fixed channel system where the wiring channel region is arranged between the base cell columns.

As shown in Fig. 3a, the logic circuit information <514> is completed by automatically connecting the logic circuits arranged automatically based on the connecting information.

A part of net connecting logic elements is connected at the time of such automatic wiring, for example, as shown in Fig. 1a, so as to pass through the upper wiring layer UL. Moreover, in the first embodiment, a part of all wirings connecting the logic elements is connected to pass through the upper wiring layer UL. Therefore, the function <320> shown in Fig. 3b is supported in the automatic wiring step <514>. A part of net or all wirings connecting logic elements is guided, as the terminals 140 - 147 shown in Fig. 1b, to the lowest wiring layer in the upper wiring layer UL (the fourth wiring layer S4 in this embodiment) <522>.

Next, these terminals are connected using the upper wiring layer UL <524>.

As shown in Fig. 3a, the logic circuit information completed by the DA system is converted to the mask generation data based on the design rule in this DA system <515>. The automatic processing is carried out by the DA system from the step <511> for inputting the connecting information to the step <515> for converting the data into the mask generation data.

A connecting mask is formed by an electron beam (EB) drawing apparatus based on the mask generation data.

Thereafter, a semiconductor integrated circuit device having predetermined logic circuit structure is substantially completed <560> through device process <550> using the connecting mask.

Next, a method of correcting predetermined logic structure thus formed will be explained briefly. For correction of logic structure, the DA system <510> supports the correcting function <307> shown in Fig. 3c.

As shown in Fig. 2b, the terminals 140 - 143 of upper wiring layer UL is connected or separated in accordance with the information to correct connection between logic terminals and wiring information <520> in the upper wiring layer UL.

Next, after the step <515> for converting to the mask generating data, the semiconductor integrated circuit device having the corrected logic structure (circuit) is substantially completed <560> sequentially through the mask forming step <540> and device process step <550>.

The method of fomring a semiconductor integrated circuit device employing the master slice system formed by the DA system, as explained above, comprises the step <522> for leading a part of net or all wirings connecting logic elements to the lowest wiring layer (fourth wiring layer S4 in this embodiment) of the upper wiring layer UL and the step <524> for connecting the terminals using the upper wiring layer UL.

Thereafter, the logic correction of semiconductor integrated circuit device using the DA system comprises a step <530> for disconnecting or connecting the terminals of the upper wiring layer UL.

Namely, the semiconductor integrated circuit device having many laminated wiring layers S1- S5 constitutes a part of the net connecting logic elements or a part of wirings connecting logic elements by providing the terminals 140 147 to the wiring layer S4 of the lowest layer in the upper wiring layer and connecting terminals using the upper wiring layer UL and the logic correction (alteration) of semiconductor integrated circuit device can be realized by disconnecting or connecting the terminals.

Thereby, since the connecting pattern connecting the logic elements can be corrected by correcting only the connecting (wiring) pattern in the upper wiring layer UL, the logic structure may be corrected with the DA system within a short period of time (short term).

Moreover, since the connecting patterns of lower wiring layers S1 - S3 are altered and the step for connecting again are eliminated, it is no longer necessary to correct the mask as much as the steps mentioned above and correction of logic structure of the semiconductor integrated circuit device employing the master slice system can be done within a short period of time by reducing the number of steps of the DA system. Correction of logic structure can be realized within a short term. Namely, since only the upper wiring layer may be corrected using mask, logic correction can be realized within a short term.

Moreover, since logic correction can be done using the upper wiring layer UL consisting of the wiring layers S4, S5 of the fourth and fifth layers, a degree of freedom of logic correction by the DA system can be improved and the corrected wirings can be set short.

Embodiment 2:

The second embodiment provides unused logic elements not connected to the other logic elements in the basic cell array (logic circuit portion) within the semiconductor integrated circuit device of the embodiment 1.

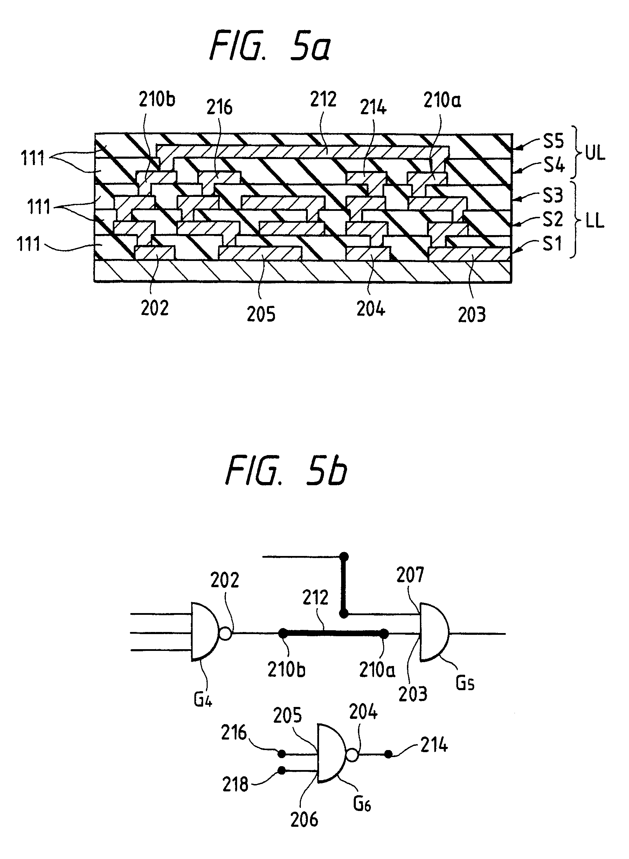

Fig. 5a shows a vertical sectional view indicating the second embodiment of the semiconductor integrated circuit board of the present invention and Fig. 5b shows a logic circuit diagram of the semiconductor integrated circuit device shown in Fig. 5a.

In Fig. 5b, gates G4, G5, G6 respectively denote logic elements, while gate G4, 3-input NAND, G5, 2-input AND and gate G6, 2-input NAND. The reference numeral 202 denotes an output terminal of gate G4; 203, 207, input terminals of gate 5; 204, an input terminal of gate G6; 205, 206, output terminals of gate G6. As shown in Fig. 5a, a part of wirings connecting the output terminal 202 of gate G4 and input terminal 203 of gate G5 passes through the foruth and fifth wiring layers S4, S5 and is constituted by the wiring 212 of fifth layer.

Namely, a part of wiring connecting the output terminal 202 of gate G4 and input terminal 203 of gate G5 is guided to the lowest wiring layer S4 in the upper wiring layer UL as the terminals 210a, 210b and these terminals are connected with the wiring 212 of the fifth layer.

The wiring end from the output terminal 204 of gate G6 is turned up to the fourth wiring layer S4 as the terminal 214, while the wiring end from the input terminals 205, 206 of gate G6 are turned up to the fourth wiring layer as the terminals 216, 218.

Here, wirings from the output/input terminals 204, 205, 206 of the gate G6 are not connected with the other wirings and therefore the gate G6 is provided as the unused gate.

As explained above, in the second embodiment, unused gate G6 is provided in the LSI and moreover the input/output terminals 214, 216, 218 of unused gate G6 are respectively led into the upper wiring layer UL (the fourth layer S4 in this embodiment).

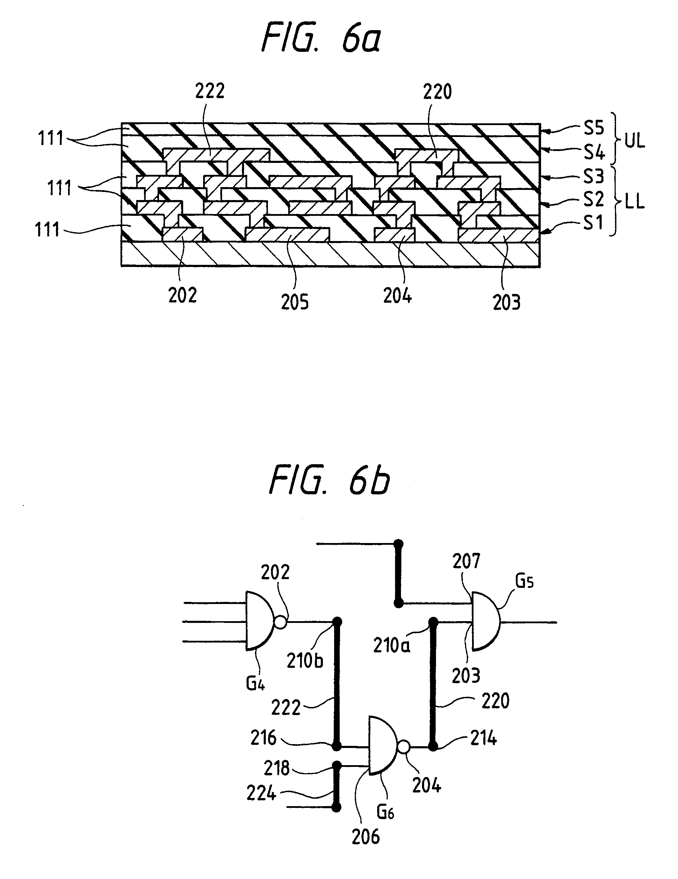

Therefore, in case the semiconductor integrated circuit device explained above is altered or corrected as shown in Fig. 6b, namely in case the gate G is added between the gate G4 and gate G5, as shown in Fig. 6a, the wiring is cut or connected only at the foruth and fifth wiring layers S4, S5.

That is, the wiring 212 of the fifth layer connecting the terminals 210a and 210b is eliminated and the terminals 210a, 214 and terminals 210b, 216 are respectively connected with the wirings 220, 222 of the fourth layer. In addition, the terminal 218 of gate G6 passes the upper wring layer 224 and is connected to the other logic elements not illustrated.

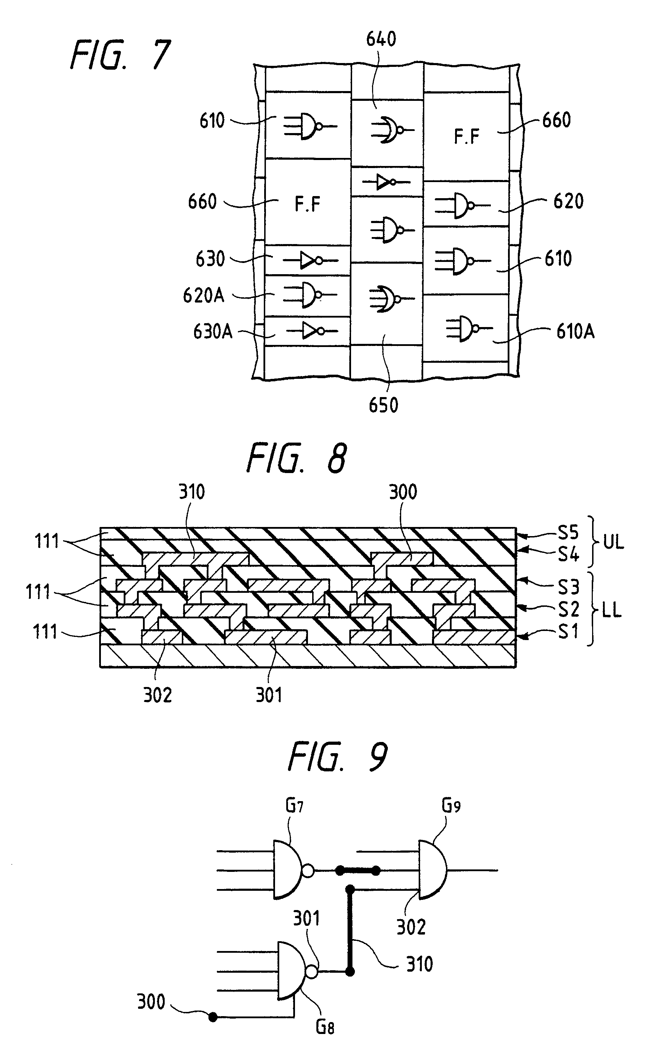

As the unused gate G6, unused logic element is arranged, but, for example, it is preferable to arrange the logic gate which is highly used (inverter, 2 3-input NAND, NOR, etc.) within LSI. Moreover, the number of unused gates is determined, for example, depending on the estimated alteration scale of circuit. Fig. 7 shows an example of the block diagram of the semiconductor integrated circuit device in which unused logic elements 610A, 620A, 630A are added.

As explained above, since unused gate G6 is provided within the LSI and the input/output terminals 214, 216, 218 of the unused gate G6 are respectively led to the upper wiring layer UL (the fourth layer S4 in this embodiment), the logic alteration can be realized only by correcting the upper wiring layer UL (S4, S5 layers in this embodiment) to which the input/output terminals 214, 216, 218 of unused gate G6 are led, without reforming the all wiring layers S1- S5.

The semiconductor integrated circuit device thus constituted provides the following effects other than that of the embodiment 1.

Even in case the logic element G6 must be added at the time of logic correction, it can be realized by correcting only the upper wiring layer UL. Therefore, logic correction may be conducted within a short period of time.

Moreover, the number of wirings to be corrected increases in some cases in such logic correction. However, since logic correction is carried out using the upper wiring layer UL consisting of the fourth and fifth wiring layers S4, S5, a degree of freedom of logic correction may be improved. The corrected wirings 220, 222, 224 may be set short, increase of delay time in the corrected logic structure can be prevented and reliability of circuit operation can also be improved.

A method of forming a semiconductor integrated circuit device utilizing unused logic element and a method of correcting logic structure will be explained briefly. The process flowchart of DA system in this embodiment is basically the same as that in Figs. 3a, 3b, 3c and only difference will be explained. As shown in Fig. 3a, in the wiring step <514>, the function for leading the terminals 214, 216, 218 of unused gate G6 is supported by the step <522> shown in Fig. 3b.

Namely, the function for leading a part of the net or all wirings connecting logic elements to the lowest wiring layer S4 in the upper wiring layer UL as the terminals 210a, 210b and leading the terminals 214, 216, 218 of unused gate (unused logic element) to the lowest layer S4 in the upper wiring layer UL is supported in the step <522>.

Next, in the step <524>, these terminals are connected using the upper wiring layer UL but the terminals 214, 216, 218 of unused gate is not connected with the other terminals.

Meanwhile, the function to connect or disconnect the termnals 210a, 210b in the upper wiring layer UL and the terminals 214, 216, 218 of unused gate on the basis of the interlogic element connection correcting information, wiring information in the upper wiring layer UL and terminal information of unused gate <520> is supported in the step <533> in order to correct the logic structure.

As explained previously, the method of forming the semiconductor integrated circuit device employing the master slice system formed by the DA system has the step <522> to leading the terminals 214, 216, 218 of unused electronic element to the lowest wiring layer S4 of the upper wiring layer UL.

Thereafter, logic correction of the semiconductor integrated circuit device using the DA system has in the step <530> for correcting wiring pattern between terminals in the upper wiring layer UL.

Thereby, the effect same as that in the embodiment 1 can be obtained.

Embodiment 3:

The embodiment 3 provides logic elements having the gate disable function in the basic cell array (logic circuit) in the semiconductor integrated circuit board of Embodiment 1.

Fig. 8 is a vertical sectional view indicating a third embodiment of the semiconductor integrated circuit device of the present invention and Fig. 9 is a logic circuit diagram of the semiconductor integrated circuit device shown in Fig. 8.

In Fig. 9, the gates G7, G8, G9 indicate logic elements; the gate G7, 2-input NAND; gate G8, 3-input NAND; gate G9, 3-input AND.

The reference numeral 300 denotes a disable terminal provided to the gate G8 and this disable terminal 300 is led, as shown in Fig. 8, to the lowest wiring layer S4 (the fourth wiring layer) in the upper wiring layer UL. Here, the disable function means that when the disable terminal 300 is turned on, an output of the gate G8 becomes low level without relation to the input.

Therefore, when an output of gate G8 becomes unnecesary, predetermined wiring is connected so that the disable terminal 300 led to the upper wiring layer UL is turned on. Thereby, an output of the gate G8 becomes low and the gate may be equivalently eliminated without correcting the lower wiring layer LL.

As explained above, in the third embodiment, the disable terminal 300 of gate G8 is led to within the upper wiring layer UL consisting of two layers, the logic correction can be made by correcting only the upper wiring layer UL, to which the disable terminal 300 is led, even without reforming all layers.

Accordingly, like the first and second embodiments, even when a number of wiring layers increases, correction of wiring layer, namely logic correction may be realized within a short period of time (term).

In the DA system, the function to lead the disable terminal 300 to the upper wiring layer UL and the function to connect the disable terminal 300 to the specified terminals can be supported respectively by the steps <522>, <530>.

Embodiment 4:

This embodiment 4 provides a spare channel in the basic cell array (logic circuit) of the semiconductor integrated circuit device of the embodiment 1.

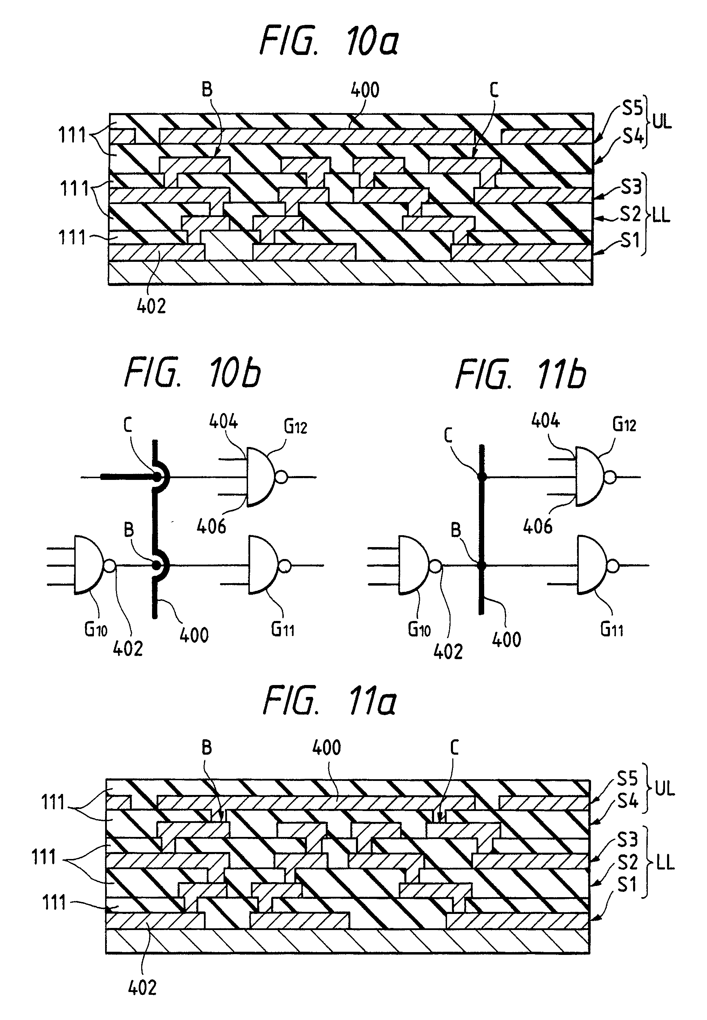

Fig. 10a is a vertical sectional view of the fourth embodiment of the semiconductor integrated circuit device of the present invention and Fig. 10b is a logic circuit diagram of the semiconductor integrated circuit device shown in Fig. 10a.

In Fig. 10b, the gates G10, G11, G12 are logic gates; gate G10, 3-input NAND; gates G11, G12, 2-input NAND.

As shown in Fig. 10a, the wiring end from the output terminal of gate G10 is led, as the terminal B, to the lowest wiring layer S4 in the upper wiring layer UL, while the wiring end from the input terminal of gate G12 is led, as the terminal C, to the lowest wiring layer S4 in the upper wiring layer UL. The terminal C is connected to the not illustrated wiring which gives high level "1" through the fourth wiring layer S4. Thereby, the gate G12 forms the 2-input NAND comprising the input terminals 404, 406.

In this semiconductor integrated circuit device, a spare channel 400 not connected to any wiring is formed to the fifth wiring layer S5 and the other gate terminal is turned up to the upper wiring layer UL (the fourth wiring layer S4 in this embodiment) as in the case of the first embodiment. This spare channel 400 is not used at the time of connection by DA and is provided as so-called forbidden area.

In this fourth embodiment, as explained above, a spare channel 400 is formed in the upper wiring layer UL of LSI (the highest fifth wiring layer S5 in this embodiment).

Here, in case of connecting the gate terminals B, C with addition of alteration on the semiconductor integrated circuit device, the gate terminals B, C are connected to the spare channel 400 as shown in Fig. 11.

In this case, connection between terminal C and the wiring giving the level "1" is cut.

Namely, the correction may be carried out, without forming a new wiring layer, only by forming the connecting hole to connect the fourth and fifth wiring layers and cutting the connection. Moreover, it is no longer necessary to correct the connecting pattern of the lower wiring layers LL (S1-S3), namely to correct the mask.

As explained above, in the fourth embodiment, since the spare channel 400 is formed within the two layers of the upper wiring layer of LSI (the fifth wiring layer S5 in this embodiment), it is no longer necessary to reform all wiring layers S1 - S5 and moreover logic correction may be carried out by forming the connecting holes in the upper layer.

Therefore, correction of wiring layer, namely logic correction may be carried out within a short period of time (term) even when the number of wiring layers increases, like the first, second and third embodiments explained above.

In the embodiments explained above, a part of all wirings is provided to pass, unused gate terminal is turned up, disable terminal is provided and a spare channel is formed within two layers of upper wiring layer UL, but the wiring layer to which such structures are applied is not limited only to the upper two layers and can also be applied within three or four layers. Particularly when the number of wiring layers increases, the number of upper layers is thought to be more increased than two layers in each embodiment in view of enhancing a degree of freedom in the logic correction.

Moreover, it is also possible to form the semiconductor integrated circuit device by combining the structures that a net or a part of all wiring is caused to pass through the upper wiring layer UL, terminals of unused gate are turned up, disable terminal is provided and spare channel is formed explained in respective embodimetns described above.

Correction of upper wiring layer UL in the semiconductor integrated circuit device explained above can also be realized by an apparatus such as FIB (Focused Ion Beam) apparatus which can form or disconnect local wirings after forming the wiring layers up to the upper layer. Namely, in case the five wiring layers are used like each embodiment, all wiring layers up to the fifth layer are formed previously and thereafter correction of wiring can be done by conducting local correction of the fourth and fifth wiring layers S4, S5 with the FIB apparatus.

Therefore, in this method, any correction is not carried out for the lower wiring layer LL (S1 - S3) than the upper wiring layer UL and logic correction is carried out without using mask. Namely, this method is preferable in such a point that correction can be done within a very short period (term).

In the case of correcting wirings with the FIB apparatus like this method, the wiring interval in the upper wiring layer UL must be set larger and thereby attention should be paid to the points that the number of wirings is reduced and application efficiency of logic elements is lowered. Namely, the semiconductor integrated circuit device formed to conduct logic correction with the FIB apparatus shows lower application efficiency of logic elements than that of the semiconductor integrated circuit device formed to conduct the logic correction using mask. It is because more detail mask pattern can be formed since the mask correction is carried out with the EB drawing method.

The effect obtained by the typical inventions among those disclosed in the present specification may be briefly explained as follow.

Namely, the wiring layers are formed in a semiconductor integrated circuit device having many liminated wiring layers UL, LL so that correction of wiring layer can be carried out only at the upper wiring layer UL. Thereby, correction only at the upper wiring layer UL is required without reformation of all layers during the correction. As a result, correction of wiring layers, namely logic correction can be realized within a short period of time (term) without relation to the number of wiring layers.

Moreover, since the connecting pattern between logic elements is altered during correction of upper wiring layer consisting of two or more wiring layers, reliability of circuit operation after logic correction can be much improved.

In addition, since logic correction is carried out using unused logic elements not connected with the other logic elements, a degree of freedom for logic correction can be improved.

While the inventions disclosed by the inventors have been explained with respect to the specific embodiments thereof, it is to be understood that the present invention is not limited thereto in any way but covers any and all changes and modifications which will become possible within the scope of the claims.

The typical inventions explained with respect to the embodiments will be briefly explained hereunder.

In a semiconductor integrated circuit device comprising a logic element G provided on a semiconductor substrate 600 and a laminated wiring layer formed by alternately laminating insulating films 111 and wiring layers S1 - S5 on the logic elements G, by which the logic elements G are connected with laminated wiring layers,

the laminated wiring layers are formed by lower wiring layers LL (S1 - S3) and uper wiring layers UL (S4, S5) on the lower wiring layers LL,

a part of net connecting logic elements G is provided with terminals 140 - 147 within the upper wiring layer UL, and

the terminals 140 147 are connected with the upper wiring layer UL.

Namely a part of the net passes through the wiring layers.

Moreover, the semiconductor integrated circuit device comprises, moreover, unused logic element G not connected with the other logic elements and logic element G having disable terminal 300, wherein the input/output terminals 214, 216, 218 of the unused logic element and disable termial 300 are led into the upper wiring layer UL.

Logic correction of the semiconductor integrated circuit device can be carried out by changing connecting pattern between the terminals 140 - 147 as a part of the net using the upper wiring layer UL, connecting the input/output terminals 214, 216, 218 of unused logic element of the other teminals 210a, 210b and connecting the disable terminal 300 to the determined wirings.

Namely, in a semiconductor integrated circuit device comprising many laminated wiring layers S1, S2,...., these wiring layers are structured so that correction of wiring layers can be realized only at the upper wiring layer UL.

**Claims**

1. A semiconductor integrated circuit device comprising,

logic elements (G) provided on a semiconductor substrate (600) and laminated wiring layers formed by alternately laminating insulation layers (111) and wiring layers (S1, S2, .....) on said logic elements (G), said logic elements (G) being connected with said laminated wiring layers, characterized in

that said each laminated wiring layer is comprised of a lower wiring layer (LL) and an upper wiring layer (UL) laid on said lower wiring layer (LL), and

that a part of a net connecting the logic elements (G) passes on the upper wiring layer (UL) so as to correct wirings between the logic elements (G) only with the upper wiring layer (UL).

2. The device of claim 1, wherein the net leads terminals (140 - 147) within the upper wiring layer (UL) to connect the terminals with the wirings (S4, S5) of the upper wiring layer (UL).

3. The device of claim 1 or 2, comprising an unused logic element not connected with any other logic elements, input/output terminals (214, 216, 218) of said unused logic element being led into the upper wiring layer (UL).

4. The device of any one of claims 1 to 3, comprising a logic element including a disable terminal (300) which is led into the upper wiring layer (UL).

5. The device of any one of claims 1 to 4, comprising a spare channel (400) within the upper wiring layer (UL).

6. The device of any one of claims 2 to 5, wherein correction of the upper wiring layer (UL) is carried out by altering connections among the terminals (140 - 147, 214, 216, 218, 300, 400).

7. The device of any one of claims 1 to 6, wherein said device has basic cells (604) comprising transistors on the semi-conductor substrate (600), the logic element (G) is formed by connecting between the transistors, and each transistor is a CMOS, Bi-CMOS or Bipolar transistor.

8. The device of any one of claims 1 to 7, wherein the upper wiring layer (UL) comprises two or more wiring layers.

9. The device of any one of claims 1 to 8, wherein the logic element (G) is a logic gate such as inverter, NAND and NOR.

10. A method of logic correction for semiconductor integrated circuit device comprising logic elements (G) provided on a semiconductor substrate (600) and laminated wiring layers formed by alternately laminating insulation layers (111) and wiring layers (S1, S2, .....) on the logic elements (G), said logic elements (G) being connected with said laminated wiring layers, characterized in

that said each laminated wiring layer is comprised of a lower wiring layer (LL) and an upper wiring layer (UL) laid on said lower wiring layer,

that a part of net connecting the logic elements (G) has terminals (140 - 147) in the upper wiring layers (UL), said terminals being connected <520> with the upper wiring layer (UL), and

that correction of connections between the logic elements (G) is carried out by altering connections between terminals with the upper wiring layer <533>.

11. The method of claim 10, wherein said device comprises an unused logic element not connected with any other logic elements, input/output terminals (214, 216, 218) of said unused logic element are led into the upper wiring layer (UL), and correction of connection between the logic terminals (G) is carried out by connecting the input/output terminals (214, 216, 218) and said terminals.

12. The method of claim 10 or 11, wherein said device com prises a logic element including a disable terminal (300) which is led into the upper wiring layer (UL) and correction of logic is carried out by connecting said disable terminal (300) to the predetermined wirings.

13. The method of any one of claims 10 to 12, wherein said upper wiring layer (UL) comprises two or more wiring layers.

14. The method of any one of claims 10 to 13, wherein correction of said upper wiring layer (UL) is carried out by previously forming wiring layers from the upper layer to lower layer and using a mask depending on specifications <540>.

15. The method of any one of claims 10 to 13, wherein correction of said upper wiring layer (UL) is carried out by disconnecting and connecting local wirings after wiring layers up to the uppermost layer are formed.

16. The method of any one of claims 10 to 15, wherein connections between said terminals (140 - 147) are carried out by automatic layout and wiring system.

17. The method of any one of claims 10 to 16, wherein alteration of connecting pattern between the terminals is carried out by the automatic layout and wiring system.

# FIG. 1a

# FIG. 1b

# FIG. 2a

# FIG. 2b

# FIG. 3a

```
┌─────────────────────────┐
│ LOGIC CIRCUIT DIAGRAM   │  ⟨500⟩
└─────────────────────────┘
                                        ⟨510⟩
        │
        ▼
┌─────────────────────────┐  ⟨511⟩        ⟨516⟩
│                         │      ┌─────────────────────────┐
│        NETFILE          │◄─────│      BASE DATA          │
│                         │      │     (BC PATTERN)        │
└─────────────────────────┘      └─────────────────────────┘
        │
        ▼  ⟨512⟩                           ⟨517⟩
┌─────────────────────────┐      ┌─────────────────────────┐
│   POWER SOURCE WIRING   │◄─────│        MODULE           │
│                         │      │ (LOGIC FUNCTION PATTERN)│
└─────────────────────────┘      └─────────────────────────┘
        │
        ▼
┌─────────────────────────┐  ⟨513⟩
│   AUTOMATIC PLACEMENT    │
└─────────────────────────┘
        │
        ▼
┌─────────────────────────┐  ⟨514⟩
│    AUTOMATIC ROUTING     │
└─────────────────────────┘
        │
        ▼                          AUTOMATIC PLACEMENT
┌─────────────────────────┐  ⟨515⟩ AND ROUTING SYSTEM
│     DATA FOR MASK        │       BY USING COMPUTER
│      PRODUCTION          │       (DA TREATMENT)
└─────────────────────────┘
        │
        ▼
┌─────────────────────────┐  ⟨540⟩
│    MASK PRODUCTION       │
│    (EB LITHOGRAPHY)      │
└─────────────────────────┘
        │
        ▼
┌─────────────────────────┐  ⟨550⟩
│     DEVICE PROCESS       │
└─────────────────────────┘
        │
        ▼
┌─────────────────────────┐  ⟨560⟩
│    A COMPLETENESS        │
│     OF A DEVICE          │
└─────────────────────────┘
```

13

## *FIG. 3b*

⟨520⟩

> FUNCTION FOR EXTENDING
> A TERMINAL WITHIN UPPER
> WIRING LAYERS    ⟨522⟩

> FUNCTION FOR INTERCONNECTING
> BETWEEN TERMINALS BY THE UPPER
> WIRING LAYERS    ⟨524⟩

## *FIG. 3c*

⟨530⟩

> REARRANGING THE INTERCONNECTION
> BETWEEN TERMINALS WITHIN THE
> UPPER LAYERS    ⟨533⟩

> DATA FOR MASK PRODUCTION    ⟨515⟩

> MASK PRODUCTION
> (EB LITHOGRAPHY)    ⟨540⟩

> DEVICE PROCESS    ⟨550⟩

> A COMPLETENESS OF A DEVICE    ⟨560⟩

# FIG. 4a

600

602

604

606

# FIG. 4b

640

610

660

630

620

630

650

660

620

610

610

# FIG. 5a

# FIG. 5b

## FIG. 6a

## FIG. 6b

## FIG. 7

## FIG. 8

## FIG. 9

# FIG. 10a

# FIG. 10b

# FIG. 11b

# FIG. 11a